# EUROPEAN PATENT APPLICATION

(11) **EP 1 333 510 A2**
(43) Date of publication of application: **06.08.2003**
(21) Application number: 03075173.9
(22) Date of filing: 20.01.2003
(51) Int. Cl.: H01L 51/40

(54) **Using spacer elements to make electroluminescent display devices**

(30) Priority: 30.01.2002 US 60837
(71) Applicant: EASTMAN KODAK COMPANY, Rochester, New York 14650 (US)
(72) Inventor: Burberry, Mitchell S. c/o Eastman Kodak Staff, Rochester, New York 14650-2201 (US); Tutt, Lee William, c/o Eastman Kodak Company, Rochester, New York 14650-2201 (US); Culver, Myron W. c/o Eastman Kodak Company, Rochester, New York 14650-2201 (US); Tang, Ching W. c/o Eastman Kodak Company, Rochester, New York 14650-2201 (US)
(74) Representative: Weber, Etienne Nicolas

(57) **Abstract**

A method for making an organic electroluminescent display device having an array of pixels disposed on a display substrate includes providing spacer elements either individually or as part of a donor element or a display substrate. Radiation-induced thermal transfer is then used to transfer organic material from the donor element to the display substrate.

## Description

The present invention relates to a method of making organic electroluminescent devices and, more particularly, to using radiation-induced thermal transfer of organic materials to produce display elements.

In color or full-color organic electroluminescent (EL) displays having an array of colored pixels such as red, green, and blue color pixels (commonly referred to as RGB pixels), precision patterning of the color producing organic EL media is required to produce the RGB pixels. The basic organic EL device has in common an anode, a cathode, and an organic EL medium sandwiched between the anode and the cathode. The organic EL medium may consist of one or more layers of organic thin films, where one of the layers or regions within a layer is primarily responsible for light generation or electroluminescence. This particular layer is generally referred to as the light-emitting layer of the organic EL medium. Other organic layers that may be present in the organic EL medium commonly facilitate electronic transportation, such as a hole-transporting layer (for hole conduction) or an electron-transporting layer (for electron conduction). In forming the RGB pixels in a full-color organic EL display panel, it is necessary to devise a method to precisely pattern the light-emitting layer of the organic EL medium or the entire organic EL medium.

Typically, electroluminescent pixels are formed on the display by shadow masking techniques, such as shown in US-A-5,742,129. Although this has been effective, it has several drawbacks. It has been difficult to achieve high resolution of pixel sizes using shadow masking. Moreover, there are problems of alignment between the substrate and the shadow mask, and care must be taken that pixels are formed in the appropriate locations. When it is desirable to increase the substrate size, it is difficult to manipulate the shadow mask to form appropriately positioned pixels. A further disadvantage of the shadow mask method is that the mask holes can become plugged with time. Plugged holes on the mask lead to the undesirable result of nonfunctioning pixels on the EL display.

There are further problems with the shadow mask method, which become especially apparent when making EL devices with dimensions of more than a few inches on a side. It is extremely difficult to manufacture larger shadow masks with the required precision (hole position of ±5 micrometers) for accurately forming EL devices.

A method for patterning high resolution organic EL displays has been disclosed in US-A-5,851,709 by Grande and others. This method is comprised of the following sequences of steps: 1) providing a donor substrate having opposing first and second surfaces; 2) forming a light-transmissive, heat-insulating layer over the first surface of the donor substrate; 3) forming a light-absorbing layer over the heat-insulating layer; 4) providing the donor substrate with an array of openings extending from the second surface to the heat-insulating layer; 5) providing a transferable, color forming, organic donor layer formed on the light-absorbing layer; 6) precision aligning the donor substrate with the display substrate in an oriented relationship between the openings in the substrate and the corresponding color pixels on the device; and 7) employing a source of radiation for producing sufficient heat at the light-absorbing layer over the openings to cause the transfer of the organic layer on the donor substrate to the display substrate. A problem with the Grande and others approach is that patterning of an array of openings on the donor substrate is required. This creates many of the same problems as the shadow mask method, including the requirement for precision mechanical alignment between the donor substrate and the display substrate. A further problem is that the donor pattern is fixed and cannot be changed readily.

Using an unpatterned donor sheet and a precision light source, such as a laser, can remove some of the difficulties seen with a patterned donor. Such a method is disclosed by Littman in US-A-5,688,551, and in a series of patents by Wolk and others (US-A-6,114,088; US-A-6,140,009; US-A-6,214,520; and US-A-6,221,553). However, it has been found that the properties of the organic display materials transferred by a laser can be inferior to those deposited by conventional vapor deposition methods. Such properties include uniformity, efficiency, and stability. Thus, in order to take full advantage of the patterning advantages offered by radiation-induced thermal transfer, a need remains to improve the properties of the transferred material.

It is an object of the present invention to provide a method for patterning the organic EL medium without the limitations imposed by the conventional photolithographic or shadow mask methods.

It is another object of the present invention to provide an improved method for patterning high resolution, full color, organic EL displays.

It is another object of the invention to provide a method for patterning high resolution color EL displays without the limitation of mechanical precision alignment and allowing for dynamic alignment and simple pattern changes.

These objects are achieved by an organic electroluminescent display device having an array of pixels disposed on a display substrate, comprising the steps of:
a) providing an array of first electrodes on a display substrate;
b) providing a donor element comprising a donor support, a radiation-absorbing layer over the donor support, and at least one organic layer over the radiation-absorbing layer, wherein said organic layer comprises the material or materials to be transferred to the display substrate;
c) providing spacer elements either individually or as part of the donor element or the display substrate;
d) positioning the donor element in transfer relationship to the display substrate patterned with an array of first electrodes so that the donor element and the display substrate are in engagement with the spacer elements;
e) focusing and scanning a laser beam of sufficient power and desired spot size on the radiation-absorbing layer of the donor element to effect the transfer of selected portions of the organic layer from the donor element to designated areas corresponding to pixels on the display substrate in electrical connection with the first electrodes; and
f) providing a second electrode over the transferred organic portions on the display substrate.

### ADVANTAGES

The present invention provides an advantage in that the donor element is accurately spaced by the spacer elements from the display substrate. This gap or space ensures for uniformity of transfer of the organic layer. This invention is particularly suitable for making full color, organic EL displays with high quality and good uniformity. Another advantage of this method is that, by printing with a scanning laser beam, fine precision patterning of colored pixels can be achieved, enabling the production of high resolution displays. An advantage conferred by configuring the spaced elements as raised protrusions on the donor element is that of high quality of the display, by ensuring a gap between the donor element and the display substrate, thus producing good uniformity of transfer, without adhesion failure and without failure points caused by optical contact between the layers.
FIG. 1 shows a schematic drawing of an apparatus that is useful for transferring portions of an organic layer onto a display substrate from a donor element;
FIG. 2 is a cross sectional view which depicts, in more detail, the display substrate and the donor element with spacer elements; and
FIG. 3 shows, in cross section, a schematic of a full color organic electroluminescent display device.

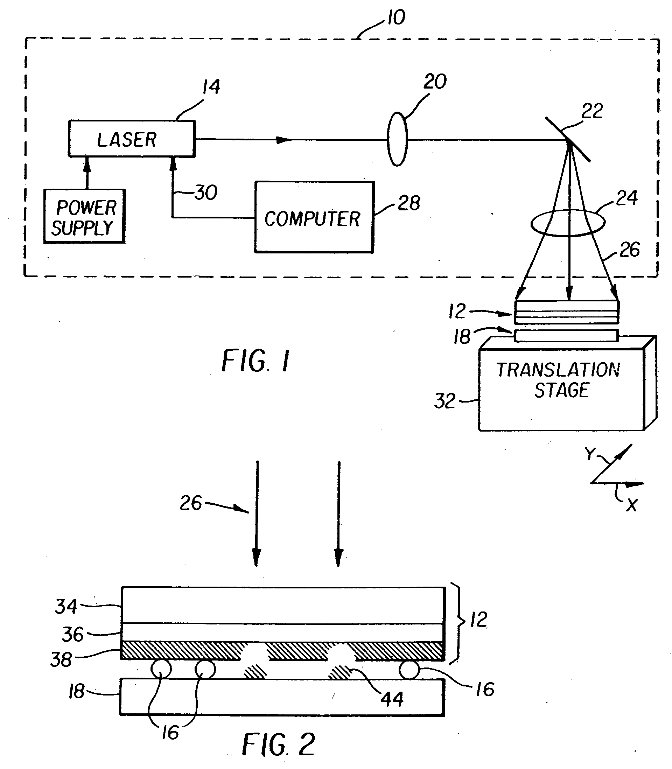

Turning now to FIG. 1, there is shown a laser printing apparatus **10** for transferring material from a donor transfer element, which will hereinafter be referred to as a donor element **12**, onto a display substrate **18** in accordance with the present invention. The laser **14** of the printing apparatus **10** can be a diode laser or any other high power laser that produces a laser beam **26**. More than one laser or laser beam can be used simultaneously in this invention. In order to scan the laser beam to provide relative movement between laser beam **26** and donor element **12**, a galvanometer **22** that includes a moveable mirror scans the beam through an f-theta lens **24** to form a line in direction X. Those skilled in the art will understand that scanning the laser beam can also be accomplished by other kinds of moveable mirrors, such as rotating polygons with mirror faces, or by other devices such as rotating diffraction gratings.

In the embodiment shown in FIG. 1, donor element **12** and display substrate **18** are transported in a direction Y, which is orthogonal to the line, by a translation stage **32** allowing the full area to be scanned. The intensity of the beam at any point in the scan is controlled by the laser power control line **30** using instructions from the computer **28**. Alternatively, the intensity of the laser beam can be controlled by a separate modulator such as an acoustooptic modulator (not shown), as is well known by those skilled in the art of laser optics. In an alternative embodiment, the substrate can remain stationary and the laser apparatus is made to move or its beam redirected optically. The important feature is that there is relative movement between the laser beam and the display substrate in order to allow full area scanning.

As shown in FIG. 2, the donor element **12** is positioned in transfer relationship to display substrate **18**. Structure, materials, and fabrication of donor element **12** and display substrate **18** are discussed in more detail below. The donor element **12** and display substrate **18** may be held in this position by clamping, application of pressure, adhesives, or the like. Donor element **12** and display substrate **18** are separated in areas by spacer elements **16**. It is preferred that transfer takes place under an inert atmosphere, such as nitrogen or argon, or under vacuum.

The f-theta lens **24** focuses the laser beam onto radiation-absorbing layer **36** of donor element **12** while the galvanometer **22** scans the laser beam. The laser beam must have sufficient power to heat radiation-absorbing layer **36** to a temperature high enough to cause the material in organic layer **38** to transfer to the display substrate **18** thereby forming transferred organic layer **44**. In one embodiment, this occurs by partial or full vaporization of the material in organic layer **38** with condensation onto the display substrate **18**. The spot size caused by the f-theta lens **24** dictates the area of the organic layer that will be transferred. The arrangement is such that, when the laser beam has sufficient power for a given rate of scan, the spot size causes material from the illuminated portion of the light emissive layer to be selectively transferred from the donor element to designated areas corresponding to pixels on the display substrate. In FIG. 2, the laser beam is shown as two spaced arrows. For convenience of illustration, it will be understood that the laser beam **26** has actually been moved between two different positions where it is turned on for transferring portions of the organic layer **38**.

In a preferred embodiment, the beam is continuously scanned by the galvanometer **22** across the donor element **12** while the laser power is modulated by instructions from the computer **28**. The modulation of laser power incident on the donor element **12** causes transfer of the organic material in organic layer **38** in selectable amounts in selected regions of the scan to the display substrate **18**. In a preferred embodiment, most or all of the material in organic layer **38** is transferred to substrate **18**.

The laser **14** can be an infrared solid-state laser, a neodynium YAG laser or any other laser providing a sufficient power to effect transfer of the organic layer. The power necessary will be dependent on the match between the absorption of the light-absorbing layer and the wavelength of the laser. The beam shape may be oval to allow small lines to be written while using low cost multimode laser.

To create a multicolor or full color display, the process is repeated for separate pixel areas using a different donor element **12** with a different organic layer **38** that will produce light of a different color when the organic EL device is fully fabricated.

In the preferred embodiment, donor element **12** used in the transfer process comprises a donor support **34** that is transmissive to the laser light, a radiation-absorbing layer **36** that converts the laser light into heat, and an organic layer **38** to be transferred. In separate embodiments, the organic layer **38** can also act as a radiation-absorbing layer and layer **36** can be eliminated. Alternatively, the support **34** can also serve as the radiation-absorbing layer, and separate layer **36** can be eliminated. Examples of donor support and radiation-absorbing materials that can be used in this invention can be found in US-A-4,772,582. The donor support must be capable of maintaining the structural integrity during the light-to-heat-induced transfer. Additionally, the donor support must be capable of receiving on one surface a relatively thin coating of organic donor material, and of retaining this coating without degradation during anticipated storage periods of the coated support. Support materials meeting these requirements include, for example, glass, metal foils, plastic (polymeric) foils which exhibit a glass transition temperature value higher than a support temperature value anticipated during transfer, and fiber-reinforced plastic foils. Plastic foils are preferred. While selection of suitable support materials can rely on known engineering approaches, it will be appreciated that certain aspects of a selected support material merit further consideration when configured as a donor support useful in the practice of the invention. For example, the support can require a multistep cleaning and surface preparation process prior to precoating with transferable organic material.

The material used in the radiation-absorbing layer **36** may be a dye such as the dyes specified in US-A-5,578,416 or a pigment such as carbon black. The radiation-absorbing layer may be a metal such as chromium, nickel or titanium, or a layered stack of materials that absorbs radiation by virtue of antireflection properties. The main criteria is that the light-absorbing layer absorbs at the wavelength of the laser emission with an optical density high enough to absorb most of the laser light, thereby producing sufficient heat to cause the organic layer to transfer. This transfer is well known to depend on the laser fluence, spot size, beam overlap and other factors. Generally, the optical density of the light-absorbing layer should be at least 0.1 (∼20% of the light is absorbed).

An important feature of the present invention is the incorporation of spacer elements **16** between the donor element **12** and the display substrate **18**. The spacer elements **16** may be unattached particles or beads between the two composites, or can be attached to either the donor element **12** or the display substrate **18**. They can also be integrally formed protrusions extending from the donor support **34**, the radiation-absorbing layer **36** or the display substrate **18**. In a preferred embodiment of the invention, the donor support **34** is a polyimide film and the spacer elements **16** are protrusions as part of the surface texture of the polyimide film. The advantage conferred by the spacer elements **16** lies in the quality and uniformity of the final display element prepared by the methods described in this invention. It is believed that contact of the donor element **12** and the display substrate **18** during the time of laser transfer of the organic layer **38** can be deleterious. The spacer elements **16** prevents or minimizes this contact. It is possible that contact of the layers provides a path for heat to leak away from the organic layer **38**, thus lowering the temperature of the organic layer **38** under the influence of the laser **14**, and causing incomplete transfer. Another failure mode may be that of melt adhesion in contact areas, leading to pulling away all of the material coated on the donor element **12** when it is removed from the display substrate **18**. Whatever the mechanism of failure is, displays made with spacer elements **16** are observed to be of higher quality and uniformity than those made without spacer elements **16**.

The spacer elements **16** may be composed of the same material that is used for the unpatterned donor support **34**, a material used in display substrate **18**, or may be made of a different material, such as a polymer, for example, polystrene or polymethylmethacrylate, or may be an inorganic material such as glass, silica, or alumina, or may be a composite or mixture of any of the these materials. The spacer elements may be a patterned photoresist. The spacer elements 16 may range in height from about 1 micron to about 100 microns, and more preferably from about 2 microns to about 5 microns in size. When patterning pixels, the height of the spacer element should generally be smaller than 5 times the distance between pixels, that is, the pixel pitch, and preferably smaller than the pixel pitch. The number of spacer elements **16** should be few enough to contact no more than 10% of the area of the EL pixel, and more preferably, no more than 1% of the area of the EL pixel. The spacer elements **16** may be formed by texturing or shaping the donor support **34**, the radiation-absorbing layer **36**, or the display substrate **18**. Spacer elements **16** may be coated on the surface of the donor support **34** prior to application of layers **36** and **38**, onto the radiation-absorbing layer **36** prior to application of layer **38**, or over layer **38**. Spacer elements may be coated over the display substrate **18**.

While the foregoing description employs a laser for selective deposition of organic materials, it will be appreciated that use of spacer elements is not limited to just this embodiment. The use of spacer elements is advantageous when using any sort of radiation to heat the donor element in order to cause transfer of organic materials through vaporization whether patterned or not. This includes, for example, unpatterned or large area transfer of organic materials using a flash-lamp, an IR heater, resistive heating of a layer of the donor element by passage of an electrical current, or the like. Selective deposition is possible using any localized heating method including, but not limited to, using an optical mask between a flash-lamp and the donor. In all of these cases, the use of spacer elements provides similar advantages as with laser-induced thermal transfer.

A general description of display substrate **18**, organic materials useful for organic EL displays, and other relevant information is provided below.

The present invention can be employed in most OLED device configurations. These include very simple structures comprising a single anode and cathode, to more complex devices, such as passive matrix displays comprised of orthogonal arrays of anodes and cathodes to form pixels, and active matrix displays where each pixel is controlled independently, for example, with a thin film transistor (TFT). This invention is most advantageous when applied to full color display device fabrication.

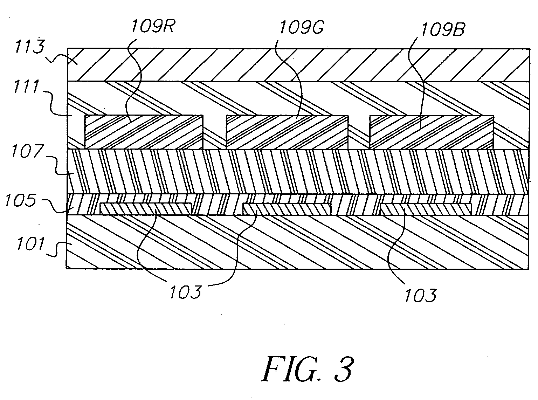

There are numerous configurations of the organic layers known in the art wherein the present invention can be successfully practiced. A typical, but not limiting, structure is shown in FIG. 3 and is comprised of a substrate **101,** independently addressable anodes **103,** an optional hole-injecting layer **105,** a hole-transporting layer **107,** a light-emitting layer **109** further defined as **109R** for red-emitting pixels, **109G** for green-emitting pixels, and **109B** for blue-emitting pixels, an electron-transporting layer **111,** and a cathode layer **113** that may or may not be independently addressable. These layers are described in detail below. Note that the substrate may alternatively be located adjacent to the cathode, or the substrate may actually constitute the anode or cathode. The electrode formed adjacent to the substrate is commonly referred to as the first electrode and the electrode formed after the organic EL materials have been deposited is commonly referred to as the second electrode. The first electrode is commonly formed in a patterned array that defines the RGB pixels. If low operating voltage is desired, the total combined thickness of the organic layers is preferably less than 500 nm.

The layer or layers transferred by this invention, that is, by radiation-induced thermal transfer, can be any one of the above. Most preferably, at least one of the layers transferred by this invention is a light-emitting layer and is formed over the patterned array of first electrodes in a spatially defined manner to create an array of pixels having a desired color, for example, red. These first electrodes are in electrical connection with the transferred light-emitting layer, either directly or through an intermediate layer such as the hole-transporting layer. Similarly, other light-emitting layers are coated by the method of this invention to form arrays of other colored pixels, for example, green and blue. By coating multiple layers onto donor element **12**, multiple layers or materials can be transferred to display substrate **18**. Depending on conditions, this transfer can occur with little, partial, or complete mixing of layers. Other device layers that do not require precision patterning may be coated by any number of methods described below. In one useful embodiment, the light-emitting layer in each pixel is deposited by laser transfer and the other layers are blanket applied by conventional sublimation.

The substrate **101** can either be light-transmissive or opaque, depending on the intended direction of light emission. The light-transmissive property is desirable for viewing the EL emission through the substrate. Transparent glass or plastic are commonly employed in such cases. For applications where the EL emission is viewed through the top electrode, the transmissive characteristic of the bottom support is immaterial, and therefore can be light-transmissive, light-absorbing or light reflective. Substrates for use in this case include, but are not limited to, glass, plastic, semiconductor materials, ceramics, and circuit board materials. Of course, it is necessary to provide in these device configurations a light-transparent top electrode.

The conductive anode layer **103** is commonly formed over the substrate and, when EL emission is viewed through the anode, should be transparent or substantially transparent to the emission of interest. Common transparent anode materials used in this invention are indium-tin oxide (ITO) and tin oxide, but other metal oxides can work including, but not limited to, aluminum- or indium-doped zinc oxide (IZO), magnesium-indium oxide, and nickel-tungsten oxide. In addition to these oxides, metal nitrides, such as gallium nitride, and metal selenides, such as zinc selenide, and metal sulfides, such as zinc sulfide, can be used in layer **103.** For applications where EL emission is viewed through the top electrode, the transmissive characteristics of layer **103** are immaterial and any conductive material can be used, transparent, opaque or reflective. Example conductors for this application include, but are not limited to, gold, iridium, molybdenum, palladium, and platinum. Typical anode materials, transmissive or otherwise, have a work function of 4.1 eV or greater. Desired anode materials are commonly deposited by any suitable means such as evaporation, sputtering, chemical vapor deposition, or electrochemical means. Anodes can be patterned using well known photolithographic processes.

While not always necessary, it is often useful that a hole-injecting layer **105** be provided between anode **103** and hole-transporting layer **107**. The hole-injecting material can serve to improve the film formation property of subsequent organic layers and to facilitate injection of holes into the hole-transporting layer. Suitable materials for use in the hole-injecting layer include, but are not limited to, porphyrinic compounds as described in US-A-4,720,432, and plasma-deposited fluorocarbon polymers as described in US-A-6,208,075. Alternative hole-injecting materials reportedly useful in organic EL devices are described in EP 0 891 121 A1 and EP 1 029 909 A1.

The hole-transporting layer **107** of the organic EL device contains at least one hole-transporting compound such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel and others in US-A-3,180,730. Other suitable triarylamines substituted with one or more vinyl radicals and/or comprising at least one active hydrogen containing group are disclosed by Brantley and others in US-A-3,567,450 and US-A-3,658,520.

A more preferred class of aromatic tertiary amines are those which include at least two aromatic tertiary amine moieties as described in US-A-4,720,432 and US-A-5,061,569. Such compounds include those represented by structural formula (A): 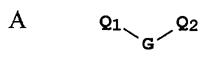 wherein:
Q₁ and Q₂ are independently selected aromatic tertiary amine moieties; and
G is a linking group such as an arylene, cycloalkylene, or alkylene group of a carbon to carbon bond.
In one embodiment, at least one of Q₁ or Q₂ contains a polycyclic fused ring structure, for example, a naphthalene. When G is an aryl group, it is conveniently a phenylene, biphenylene, or naphthalene moiety.

A useful class of triarylamines satisfying structural formula (A) and containing two triarylamine moieties is represented by structural formula (B): 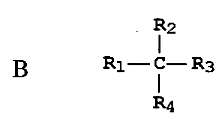 wherein:
R₁ and R₂ each independently represents a hydrogen atom, an aryl group, or an alkyl group or R₁ and R₂ together represent the atoms completing a cycloalkyl group; and
R₃ and R₄ each independently represents an aryl group, which is in turn substituted with a diaryl substituted amino group, as indicated by structural formula (C): 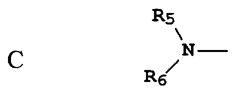
wherein:
R₅ and R₆ are independently selected aryl groups.
In one embodiment, at least one of R₅ or R₆ contains a polycyclic fused ring structure, for example, a naphthalene.

Another class of aromatic tertiary amines are the tetraaryldiamines. Desirable tetraaryldiamines include two diarylamino groups, such as indicated by formula (C), linked through an arylene group. Useful tetraaryldiamines include those represented by formula (D): 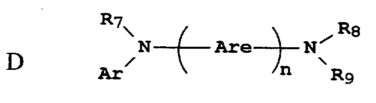 wherein:
each Are is an independently selected arylene group, such as a phenylene or anthracene moiety;
n is an integer of from 1 to 4; and
Ar, R₇, R₈, and R₉ are independently selected aryl groups.
In a typical embodiment, at least one of Ar, R₇, R₈, and R₉ is a polycyclic fused ring structure, for example, a naphthalene

The various alkyl, alkylene, aryl, and arylene moieties of the foregoing structural formulae (A), (B), (C), (D), can each in turn be substituted. Typical substituents include alkyl groups, alkoxy groups, aryl groups, aryloxy groups, and halogen such as fluoride, chloride, and bromide. The various alkyl and alkylene moieties typically contain from about 1 to 6 carbon atoms. The cycloalkyl moieties can contain from 3 to about 10 carbon atoms, but typically contain five, six, or seven ring carbon atoms - for example, cyclopentyl, cyclohexyl, and cycloheptyl ring structures. The aryl and arylene moieties are usually phenyl and phenylene moieties.

The hole-transporting layer can be formed of a single or a mixture of aromatic tertiary amine compounds. Specifically, one may employ a triarylamine, such as a triarylamine satisfying the formula (B), in combination with a tetraaryldiamine, such as indicated by formula (D). When a triarylamine is employed in combination with a tetraaryldiamine, the latter is positioned as a layer interposed between the triarylamine and the electron injecting and transporting layer. Illustrative of useful aromatic tertiary amines are the following:
1,1-Bis(4-di-***p***-tolylaminophenyl)cyclohexane
1,1-Bis(4-di-***p***-tolylaminophenyl)-4-phenylcyclohexane
4,4'-Bis(diphenylamino)quadriphenyl
Bis(4-dimethylamino-2-methylphenyl)-phenylmethane N,N,N-Tri(***p***-tolyl)amine
4-(di-p-tolylamino)-4'-[4(di-***p***-tolylamino)-styryl]stilbene N,N,N',N'-Tetra-***p***-tolyl-4-4'-diaminobiphenyl N,N,N',N'-Tetraphenyl-4,4'-diaminobiphenyl N,N,N',N'-tetra-1-naphthyl-4,4'-diaminobiphenyl N,N,N',N'-tetra-2-naphthyl-4,4'-diaminobiphenyl N-Phenylcarbazole
4,4'-Bis[N-(1-naphthyl)-N-phenylamino]biphenyl (NPB)
4,4'-Bis[N-(1-naphthyl)-N-(2-naphthyl)amino]biphenyl
4,4"-Bis[N-(1-naphthyl)-N-phenylamino]p-terphenyl
4,4'-Bis[N-(2-naphthyl)-N-phenylamino]biphenyl
4,4'-Bis[N-(3-acenaphthenyl)-N-phenylamino]biphenyl
1,5-Bis[N-(1-naphthyl)-N-phenylamino]naphthalene
4,4'-Bis [N-(9-anthryl)-N-phenylamino]biphenyl
4,4"-Bis[N-(1-anthryl)-N-phenylamino]-***p***-terphenyl
4,4'-Bis[N-(2-phenanthryl)-N-phenylamino]biphenyl
4,4'-Bis[N-(8-fluoranthenyl)-N-phenylamino]biphenyl
4,4'-Bis[N-(2-pyrenyl)-N-phenylamino]biphenyl
4,4'-Bis[N-(2-naphthacenyl)-N-phenylamino]biphenyl
4,4'-Bis[N-(2-perylenyl)-N-phenylamino]biphenyl
4,4'-Bis[N-(1-coronenyl)-N-phenylamino]biphenyl
2,6-Bis(di-***p***-tolylamino)naphthalene
2,6-Bis[di-(1-naphthyl)amino]naphthalene
2,6-Bis[N-(1-naphthyl)-N-(2-naphthyl)amino]naphthalene N,N,N',N'-Tetra(2-naphthyl)-4,4"-diamino-***p***-terphenyl
4,4'-Bis {N-phenyl-N-[4-(1-naphthyl)-phenyl]amino}biphenyl
4,4'-Bis[N-phenyl-N-(2-pyrenyl)amino]biphenyl
2,6-Bis[N,N-di(2-naphthyl)amine]fluorene
1,5-Bis[N-(1-naphthyl)-N-phenylamino]naphthalene

Another class of useful hole-transporting materials includes polycyclic aromatic compounds as described in EP 1 009 041. In addition, polymeric hole-transporting materials can be used such as poly(N-vinylcarbazole) (PVK), polythiophenes, polypyrrole, polyaniline, and copolymers such as poly(3,4-ethylenedioxythiophene)/poly(4-styrenesulfonate) also called PEDOT/PSS.

As more fully described in US-A-4,769,292 and US-A-5,935,721, the light-emitting layer (LEL) **109** of the organic EL element comprises a luminescent or fluorescent material where electroluminescence is produced as a result of electron-hole pair recombination in this region. The light-emitting layer can be comprised of a single material, but more commonly consists of a host material doped with a guest compound or compounds where light emission comes primarily from the dopant and can be of any color. The host materials in the light-emitting layer can be an electron-transporting material, as defined below, a hole-transporting material, as defined above, or another material or combination of materials that support hole-electron recombination. The dopant is usually chosen from highly fluorescent dyes, but phosphorescent compounds, for example, transition metal complexes as described in WO 98/55561, WO 00/18851, WO 00/57676, and WO 00/70655 are also useful. Dopants are typically coated as 0.01 to 10 % by weight into the host material. Different host/dopant combinations are used for different light-emitting pixels.

An important relationship for choosing a dye as a dopant is a comparison of the bandgap potential which is defined as the energy difference between the highest occupied molecular orbital and the lowest unoccupied molecular orbital of the molecule. For efficient energy transfer from the host to the dopant molecule, a necessary condition is that the band gap of the dopant is smaller than that of the host material.

Host and emitting molecules known to be of use include, but are not limited to, those disclosed in US-A-4,769,292; US-A-5,141,671; US-A-5,150,006; US-A-5,151,629; US-A-5,405,709; US-A-5,484,922; US-A-5,593,788; US-A-5,645,948; US-A-5,683,823; US-A-5,755,999; US-A-5,928,802; US-A-5,935,720; US-A-5,935,721; and US-A-6,020,078.

Metal complexes of 8-hydroxyquinoline and similar derivatives (Formula E) constitute one class of useful host compounds capable of supporting electroluminescence, and are particularly suitable for light emission of wavelengths longer than 500 nm, for example, green, yellow, orange, and red. 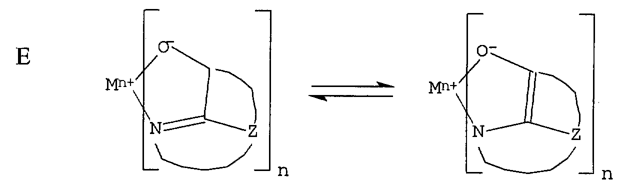 wherein:
M represents a metal;
n is an integer of from 1 to 4; and
Z independently in each occurrence represents the atoms completing a nucleus having at least two fused aromatic rings.

From the foregoing it is apparent that the metal can be monovalent, divalent, trivalent, or tetravalent metal. The metal can, for example, be an alkali metal, such as lithium, sodium, or potassium; an alkaline earth metal, such as magnesium or calcium; an earth metal, such aluminum or gallium, or a transition metal such as zinc or zirconium. Generally any monovalent, divalent, trivalent, or tetravalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function, the number of ring atoms is usually maintained at 18 or less.

Illustrative of useful chelated oxinoid compounds are the following:
CO-1: Aluminum trisoxine [alias, tris(8-quinolinolato)aluminum(III), alias ALQ]
CO-2: Magnesium bisoxine [alias, bis(8-quinolinolato)magnesium(II)]
CO-3: Bis[benzo{f}-8-quinolinolato]zinc (II)
CO-4: Bis(2-methyl-8-quinolinolato)aluminum(III)-µ-oxo-bis(2-methyl-8-quinolinolato) aluminum(III)
CO-5: Indium trisoxine [alias, tris(8-quinolinolato)indium]
CO-6: Aluminum tris(5-methyloxine) [alias, tris(5-methyl-8-quinolinolato) aluminum(III)]
CO-7: Lithium oxine [alias, (8-quinolinolato)lithium(I)]
CO-8: Gallium oxine [alias, tris(8-quinolinolato)gallium(III)]
CO-9: Zirconium oxine [alias, tetra(8-quinolinolato)zirconium(IV)]

Derivatives of 9,10-di-(2-naphthyl)anthracene (Formula F) constitute one class of useful hosts capable of supporting electroluminescence, and are particularly suitable for light emission of wavelengths longer than 400 nm, for example, blue, green, yellow, orange or red. 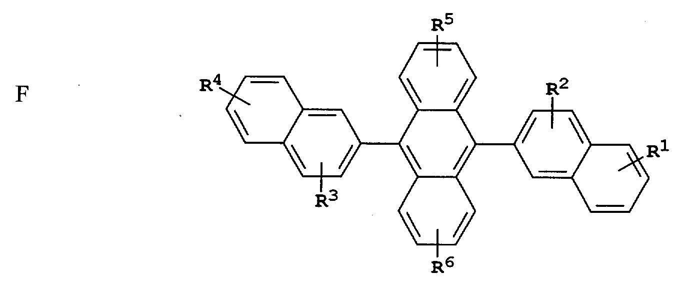 wherein:
R¹, R², R³, R⁴, R⁵, and R⁶ represent one or more substituents on each ring where each substituent is individually selected from the following groups:
   Group 1: hydrogen, or alkyl of from 1 to 24 carbon atoms;
   Group 2: aryl or substituted aryl of from 5 to 20 carbon atoms;
   Group 3: carbon atoms from 4 to 24 necessary to complete a fused aromatic ring of anthracenyl; pyrenyl, or perylenyl;
   Group 4: heteroaryl or substituted heteroaryl of from 5 to 24 carbon atoms as necessary to complete a fused heteroaromatic ring of furyl, thienyl, pyridyl, quinolinyl or other heterocyclic systems;
   Group 5: alkoxylamino, alkylamino, or arylamino of from 1 to 24 carbon atoms; and
   Group 6: fluorine, chlorine, bromine or cyano.

Illustrative examples include 9,10-di-(2-naphthyl)anthracene and 2-t-butyl-9,10-di-(2-naphthyl)anthracene (TBADN). Other anthracene derivatives can be useful as a host in the LEL, including derivatives of 9,10-bis[4-(2,2-diphenylethenyl)phenyl]anthracene.

Benzazole derivatives (Formula G) constitute another class of useful hosts capable of supporting electroluminescence, and are particularly suitable for light emission of wavelengths longer than 400 nm, for example, blue, green, yellow, orange or red. 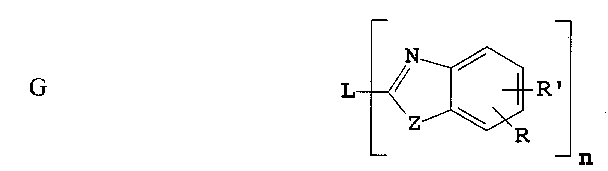 wherein:
n is an integer of 3 to 8;
Z is O, NR or S;
R and R' are individually hydrogen; alkyl of from 1 to 24 carbon atoms, for example, propyl, t-butyl, heptyl, and the like; aryl or hetero-atom substituted aryl of from 5 to 20 carbon atoms, for example, phenyl and naphthyl, furyl, thienyl, pyridyl, quinolinyl and other heterocyclic systems; or halo such as chloro, fluoro; or atoms necessary to complete a fused aromatic ring; and
L is a linkage unit consisting of alkyl, aryl, substituted alkyl, or substituted aryl, which conjugately or unconjugately connects the multiple benzazoles together.

An example of a useful benzazole is 2, 2', 2"-(1,3,5-phenylene)tris [1-phenyl-1H-benzimidazole].

Desirable fluorescent dopants include derivatives of anthracene, tetracene, xanthene, perylene, rubrene, coumarin, rhodamine, quinacridone, dicyanomethylenepyran compounds, thiopyran compounds, polymethine compounds, pyrilium and thiapyrilium compounds, and carbostyryl compounds. Illustrative examples of useful dopants include, but are not limited to, the following:

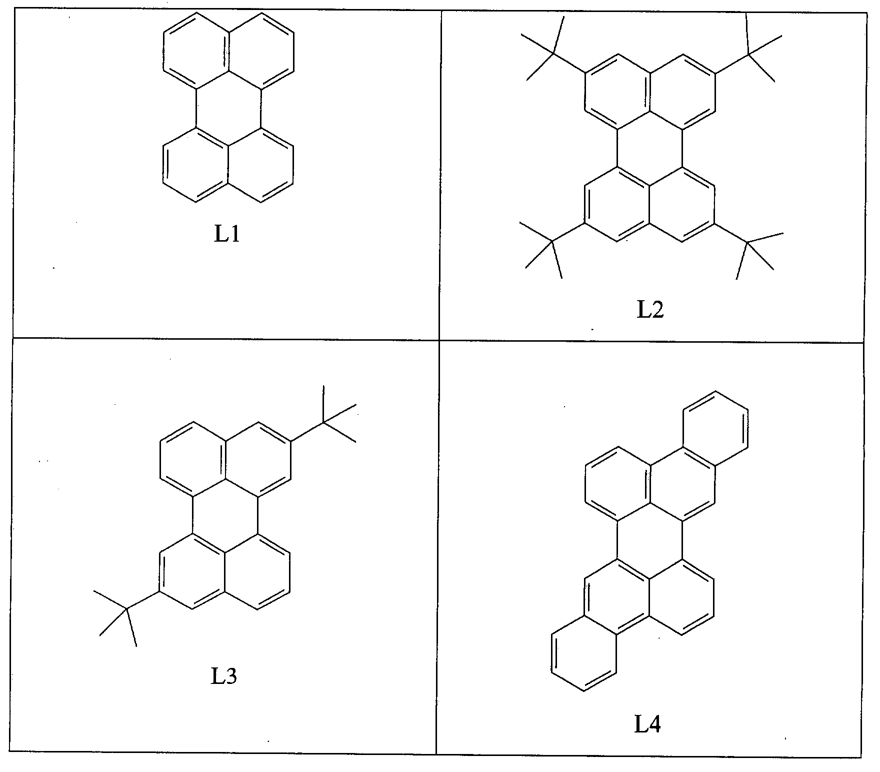

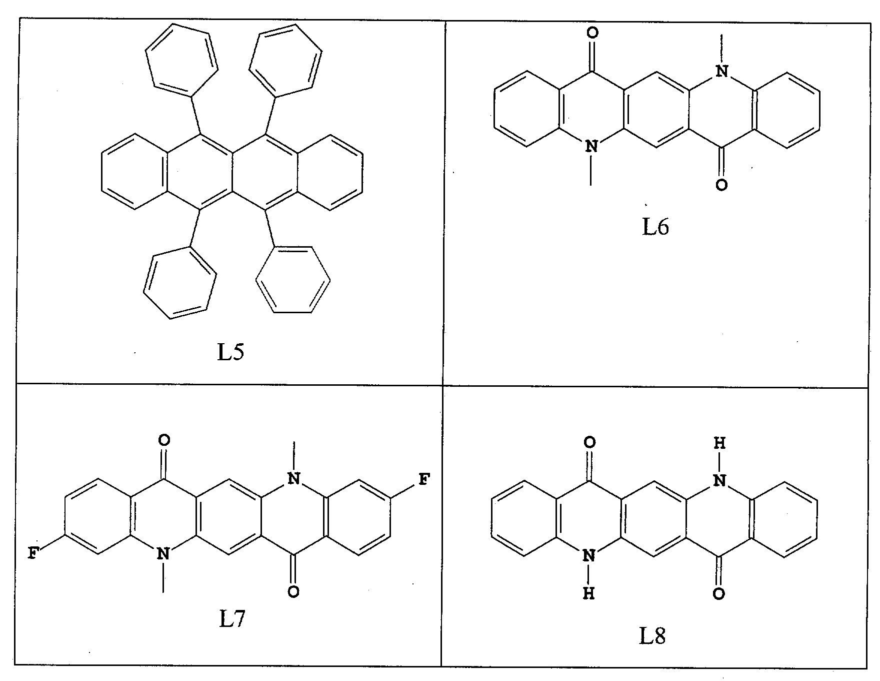

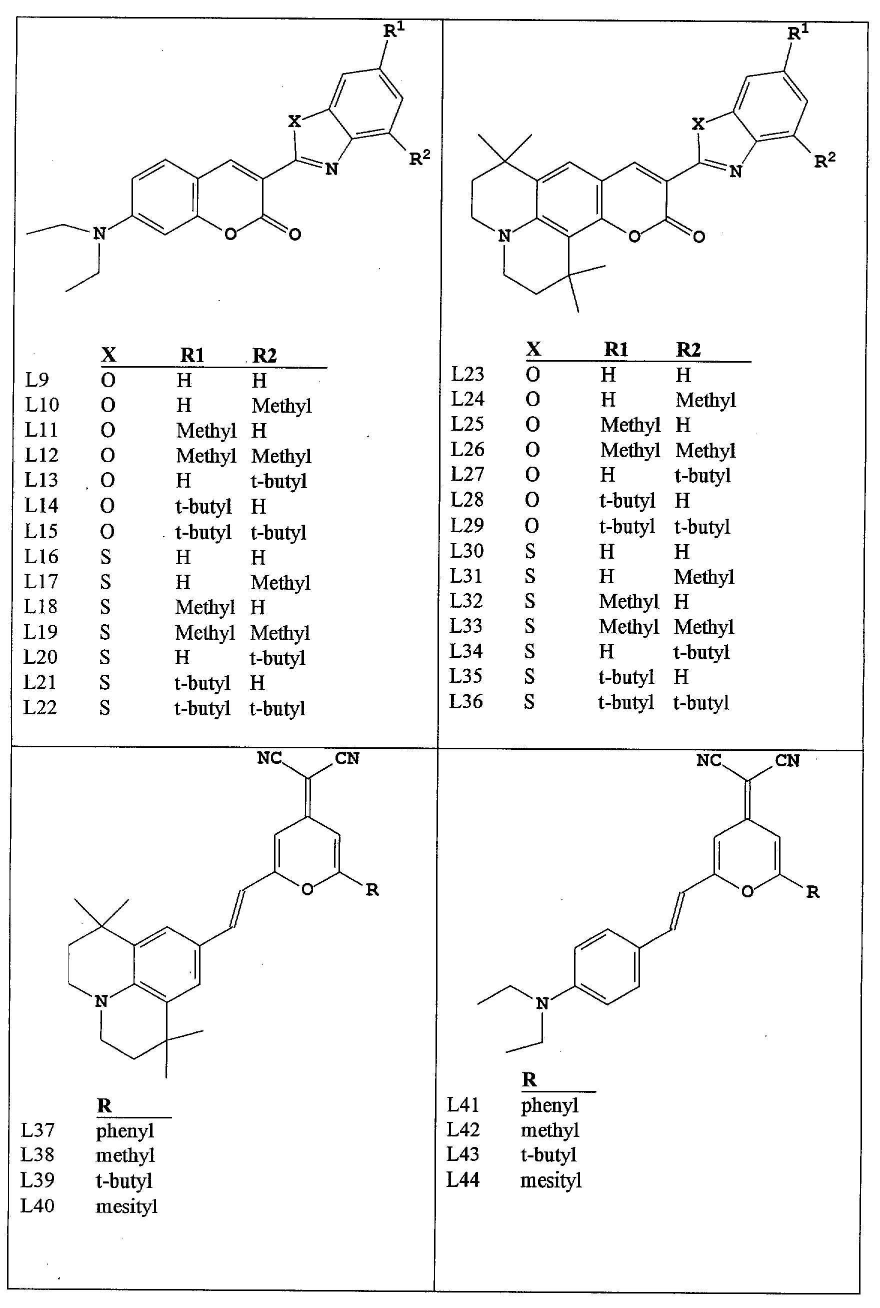

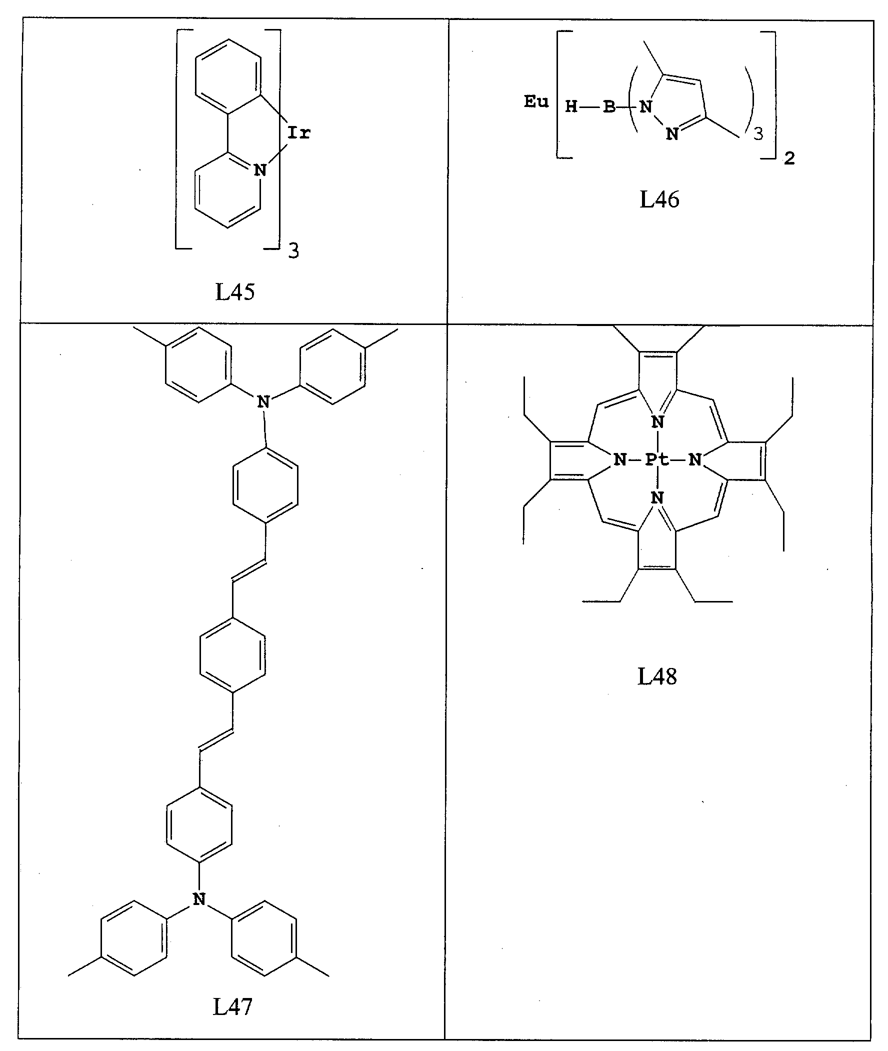

Preferred thin film-forming materials for use in forming the electron-transporting layer **111** of the organic EL devices of this invention are metal chelated oxinoid compounds, including chelates of oxine itself (also commonly referred to as 8-quinolinol or 8-hydroxyquinoline). Such compounds help to inject and transport electrons and exhibit both high levels of performance and are readily fabricated in the form of thin films. Exemplary of contemplated oxinoid compounds are those satisfying structural formula (E), previously described.

Other electron-transporting materials include various butadiene derivatives as disclosed in US-A-4,356,429 and various heterocyclic optical brighteners as described in US-A-4,539,507. Benzazoles satisfying structural formula (G) are also useful electron-transporting materials.

In some instances, layers **109** and **111** can optionally be collapsed into a single layer that serves the function of supporting both light emission and electron transportation. Similarly, layers **109** and **107** can optionally be collapsed into a single layer that serves the function of supporting both light emission and hole transportation.

When light emission is through the anode, the cathode layer **113** used in this invention can be comprised of nearly any conductive material. Desirable materials have good film-forming properties to ensure good contact with the underlying organic layer, promote electron injection at low voltage, and have good stability. Useful cathode materials often contain a low work function metal (< 4.0 eV) or metal alloy. One preferred cathode material is comprised of a Mg:Ag alloy wherein the percentage of silver is in the range of 1 to 20 %, as described in US-A-4,885,221. Another suitable class of cathode materials includes bilayers comprised of a thin layer of a low work function metal or metal salt capped with a thicker layer of conductive metal. One such cathode is comprised of a thin layer of LiF followed by a thicker layer of A1 as described in US-A-5,677,572. Other useful cathode materials include, but are not limited to, those disclosed in US-A-5,059,861; US-A-5,059,862; and US-A-6,140,763.

When light emission is viewed through the cathode, the cathode must be transparent or nearly transparent. For such applications, metals must be thin or one must use transparent conductive oxides, or a combination of these materials. Optically transparent cathodes have been described in more detail in US-A-5,776,623. Cathode materials can be deposited by evaporation, sputtering, or chemical vapor deposition. When needed, patterning can be achieved through many well known methods including, but not limited to, through-mask deposition, integral shadow masking as described in US-A-5,276,380 and EP 0 732 868, laser ablation, and selective chemical vapor deposition.

Non-patternwise deposition of the organic materials mentioned above, for example, onto the display substrate 18 or to form organic layer 38 over the donor support, is suitably accomplished through sublimation. However, organic materials may also deposited from a solvent with an optional binder to improve film formation. If the material is a polymer, solvent deposition is usually preferred. The material to be deposited by sublimation can be vaporized from a sublimator "boat" often comprised of a tantalum material, for example as described in US-A-6,237,529. Note that layers not requiring patterning may first be deposited onto a support to form donor element 12 and then sublimed in closer proximity to the substrate via unpatterned flash-lamp deposition. Layers requiring a mixture of materials can utilize separate sublimator boats or the materials can be premixed and coated from a single boat or donor sheet.

Most OLED devices are sensitive to moisture and/or oxygen so they are commonly sealed in an inert atmosphere such as nitrogen or argon, along with a desiccant such as alumina, bauxite, calcium sulfate, clays, silica gel, zeolites, alkaline metal oxides, alkaline earth metal oxides, sulfates, or metal halides and perchlorates. Methods for encapsulation and desiccation include, but are not limited to, those described in US-A-6,226,890.

### EXAMPLES

Characterization of uniform beads or protrusions as spacer elements **16** is straightforward. When a rough surfaced material is used as the donor support **34**, characterization of materials that are of effective use in this invention as opposed to those that are ineffective is more complicated. It can be observed that displays made from rough supports used for the donor support **34** yield better pixel uniformity and higher light emitting efficiency than do displays made with smooth supports used for the donor support **34**. In order to characterize the required roughness for an improved EL device, a series of supports of varying roughness were used as the donor support **34**. The substrates were a solvent cast polyimide, a thermoplastic polyimide, a polyetherimide, a polysulfone, a polyethylene napthalate, and a polyethyleneterephthalate. Samples of these supports were held against a plane glass platen by approximate 1 atmosphere vacuum. Colored Newton's rings, which are caused by close contact of two surfaces, were seen with the smooth supports, but not with rough supports The roughness of the surface could be characterized by a Newton's Ring Test as follows: samples of the different supports were held against a flat plane glass platen by vacuum. Under white light reflection microscopy, an area of about 3.1 mm by 2.3 mm was photographed with a digital camera, producing a 300 by 225 pixel full color image of the Newton rings. The images were converted to L*a*b* color space data using Adobe Photoshop® software. The differences between the highest and lowest values of a* (Δa*) were recorded as a measure of the color shift caused by the Newton's rings. These data are shown in Table 1.

**Table 1**

| Donor support | Visual Newton Rings | Δa* | EL Display Quality |
|---|---|---|---|
| Thermoplastic polyimide | None | 14 | Very good |
| Polyetherimide | None | 28 | Good |
| Polysulfone | None | 31 | Good |
| Solvent cast polyimide | Faint | 43 | Good |
| Polyethylene naphthalate | Strong | 88 | Bad |
| Polyethylene terephthalate | Strong | 93 | Bad |

A donor element 12 was formed by the vacuum deposition of a radiation-absorbing layer 36 of 60 nm of chromium onto a donor support **34** as indicated in Table 1. Onto this was vacuum deposited a 10 nm thick layer of 2-*tert*-butyl-9,10-bis(2-naphthyl)anthracene (TBADN) followed by 0.1 nm of compound L2 (TBP) to form the organic layer **38**.

A clean glass substrate was vacuum deposited and patterned with a 40 to 80 nm indium tin oxide (ITO) to form an anode. A 75 nm 4, 4'-bis[N-(1-naphthyl)-N-phenylamino]biphenyl (NPB) was then vacuum deposited onto the ITO. This glass/ITO/NPB structure constitutes display substrate **18**. The TBP layer of previously described donor element **12** was placed in contact with the NPB layer of display substrate **18** and held in place by the application of vacuum between the donor element **12** and the display substrate **18**.

Laser transfer was effected from the donor element **12** to the display substrate **18** by irradiation through the donor support **34** with an infrared beam at 830 nm. The beam size was approximately 16 microns by 80 microns to the 1/e² point. Scanning of the beam by a mirror galvanometer 22 was effected, through F-theta lens 20, parallel to the long axis of the beam to generate a scan line. The dwell time was 29 microseconds with a power density of ∼300 mw. A patch of donor transfer was effected by translating the display substrate 18 and donor element 12 by 6 microns per scan line perpendicular to the scan line of the beam. The transferred organic material **44** constitutes the light-emitting layer of the device and emits blue light.

Onto the transferred light-emitting layer, a 40 nm layer of compound CO-1 was vacuum deposited to form an electron-transporting layer. This was followed by a codeposition of 20 nm of silver and 200 nm of magnesium to form the cathode.

Upon the application of 9V, a blue emission was seen to occur. A control sample was prepared as above but without the laser-transferred layer. Application of 9 V to the control yielded a uniform green glow due to emission from CO-1. The emission quality of the examples prepared with the blue light-emitting layer was judged by the uniformity of the blue emission and presented in Table 1. Nonuniform transfer yielded a mottled appearance. This mottle was due to variations in both hue (green and blue) and in overall light intensity. Uniformity data are shown in Table 1 along with Newton's Ring Test data. Inspection of the table show that a value of Δa*, from the Newton's Ring Test defined herein, of at lower than about 80 is required for a usefully rough material for the display support 34, and more preferably, Δa* should be less than about 50.

Other features of the invention are included below.

The method wherein the hole-transporting layer and electron-transporting layer are deposited by unpatterned vapor deposition.

The method wherein the donor element also comprises a radiation-absorbing layer between the donor substrate and the organic material to be transferred.

The method wherein the spacer elements are integrally formed as part of the donor support.

A donor element for use in manufacturing organic electroluminescent devices, comprising:
a) a donor support;
b) a radiation-absorbing layer provided over the donor support;
c) at least one organic layer comprising the material or materials to be transferred to the display substrate; and
d) spacer elements;
wherein spacer elements are provided as part of the donor support or radiation-absorbing layer.

The donor element wherein the spacer elements are 1 to 100 micrometers in height.

The donor element wherein the spacer elements are provided as part of the donor support.

## Claims

1. A method for making an organic electroluminescent display device having an array of pixels disposed on a display substrate, comprising the steps of:
a) providing an array of first electrodes on a display substrate;
b) providing a donor element comprising a donor support, a radiation-absorbing layer over the donor support, and at least one organic layer over the radiation-absorbing layer, wherein said organic layer comprises the material or materials to be transferred to the display substrate;
c) providing spacer elements either individually or as part of the donor element or the display substrate;
d) positioning the donor element in transfer relationship to the display substrate patterned with an array of first electrodes so that the donor element and the display substrate are in engagement with the spacer elements;
e) focusing and scanning a laser beam of sufficient power and desired spot size on the radiation-absorbing layer of the donor element to effect the transfer of selected portions of the organic layer from the donor element to designated areas corresponding to pixels on the display substrate in electrical connection with the first electrodes; and
f) providing a second electrode over the transferred organic portions on the display substrate.

2. The method of claim 1 wherein the spacer elements are intregally formed as part of the donor support.

3. The method of claim 2 wherein the donor support is a polyimide film.

4. The method of claim 1 wherein the spacer elements are particles or beads.

5. The method of claim 1 wherein the spacer elements are composed of the same material provided in the donor support or are made from a polymer, photoresist, glass, silicia, or alumina, or composite mixture thereof.

6. The method of claim 1 wherein the spacer elements contact no more than 1% of the area of an EL pixel and preferably have a height from 2 microns to 5 microns.

7. The method of claim 1 further including repeating steps b)-e) to transfer different color producing organic light-emitting layers to provide a full color display device.

8. The method of claim 1 wherein said device also comprises a hole-transporting layer and an electron-transporting layer.

9. A method for making an organic electroluminescent display device having an array of pixels disposed on a display substrate, comprising the steps of:
a) providing an array of first electrodes on a display substrate;
b) providing a donor element comprising at least one organic layer comprising the material or materials to be transferred to the display substrate;
c) providing spacer elements either individually or as part of the donor element or the display substrate;
d) positioning the donor element in transfer relationship to the display substrate patterned with an array of first electrodes so that the donor element and the display substrate are in engagement with the spacer elements;
e) focusing and scanning a laser beam of sufficient power and desired spot size on the donor element to effect the transfer of selected portions of the organic layer from the donor element to designated areas corresponding to pixels on the display substrate in electrical connection with the first electrodes; and
f) providing a second electrode over the transferred organic portions on the display substrate.

10. A method for making an organic electroluminescent display device, comprising the steps of:
a) providing a display substrate having at least one first electrode;
b) providing a donor element comprising a donor support and at least one organic layer comprising the material or materials to be transferred to the display substrate;
c) providing spacer elements either individually or as part of the donor element or the display substrate;
d) positioning the donor element in transfer relationship to the display substrate so that the donor element and the display substrate are in engagement with the spacer elements;
e) providing radiation of sufficient power and desired area onto the donor element to effect the transfer of selected portions of the organic layer from the donor element to the display substrate in electrical connection with the first electrode or electrodes; and
f) providing a second electrode over some or all of the transferred organic portions on the display substrate.
